# EUROPÄISCHE PATENTSCHRIFT

(11) **EP 1 858 064 B1**
(45) Veröffentlichungstag und Bekanntmachung des Hinweises auf die Patenterteilung: **29.12.2010**
(21) Anmeldenummer: 07009105.3
(22) Anmeldetag: 05.05.2007
(51) Int. Cl.: H01L 21/335, H01L 21/28

(54) **Verfahren zur Herstellung eines Halbleiterbauelements mit einer in einer Doppelgrabenstruktur angeordneten metallischen Gateelektrode**
Method for manufacturing a semi-conductor element with a metal gate electrode assembled in a double trench structure
Procédé de fabrication d'un élément semi-conducteur doté d'une électrode porte métallique agencée dans une double structure à tranchée

(30) Priorität: 15.05.2006 DE 102006022507
(43) Veröffentlichungstag der Anmeldung: 21.11.2007
(73) Patentinhaber: United Monolithic Semiconductors GmbH, 89081 Ulm (DE)
(72) Erfinder: Behammer, Dag, 89079 Ulm (DE)
(74) Vertreter: Weber, Gerhard

(56) Entgegenhaltungen:
- WO-A-03/067664
- DE-A1- 10 117 741
- US-A- 5 364 816
- US-A1- 2004 082 158
- US-B1- 6 180 968

## Beschreibung

Die Erfindung betrifft ein Verfahren zur Herstellung eines Halbleiterbauelements, insbesondere eines pHEMT-Feldeffekttransistors, mit einer in einer Doppelgrabenstruktur angeordneten metallischen Gateelektrode.

Halbleiterbauelemente mit in einer auch als double recess bezeichneten Doppelgrabenstruktur angeordneter Gateelektrode sind in verschiedener Ausführung bekannt.

In US 5 796 132 werden die beiden Recessgräben einander durch Justage zugeordnet und bei der Ätzung durch eine Lack- oder SiN-Hard-Maske maskiert. Außerdem ist die Isolation im Falle eines pHEMTs nur durch eine Überätzung auf einer Stopschicht möglich. Dadurch entstehen Hohlräume, die später nicht mehr passiviert werden können. Der T-förmige Gatekopf wird in dem gezeigten Verfahren durch die Ätzung einer ganzflächig abgeschiedenen Metallisierung gebildet. In US 5 556 797 werden die beiden Recessgräben zwar selbstjustiert zueinander gebildet, jedoch ist es nicht möglich, einen niederohmigen T-förmigen Gatekopf zu bilden, der jedoch für Hochfrequenzanwendungen notwendig ist. Gleiches gilt auch für US 5 641 977.

Die US 2004/0082158 A1 beschreibt ein Verfahren, bei welchem auf der Halbleiterschichtenfolge mehrere Photolackschichten abgeschieden werden, in welchen für eine spätere Herstellung einer T-förmigen Gateelektrode im Lift-off-Verfahren Strukturen für den Gatekopf vorbereitet werden. In der untersten, auf der hochdotierten Kontaktschicht der Halbleiterschichtenfolge abgeschiedenen Lackschicht wird eine die Struktur des Gatefußes bestimmende Öffnung erzeugt. Die Lackschichten bleiben in den folgenden Verfahrensschritten bis zum Aufdampfen des Gatemetalls erhalten. Unter der untersten Lackschicht wird durch Unterätzung in der Kontaktschicht eine Grabenstruktur bis zu einer Barriereschicht erzeugt und das Gatemetall durch die Öffnung der untersten Lackschicht zur Bildung des Gatefußes auf der Barriereschicht und gleichzeitig in die Strukturen der oberen Lackschichten zur Bildung des Gatekopfes abgeschieden. Durch Auflösen der Lackschichten wird die Gateelektrode freigelegt. Danach werden noch ohmsche Kontakte auf der hochdotierten Kontaktschicht erzeugt.

In der US 6 180 968 B1 ist ein Heterojunction-Feldeffekttransistor beschrieben, bei welchem in oberhalb einer Kanalschicht abgeschiedenen Halbleiterschichten eine Doppelgrabenstruktur erzeugt wird. Über den Halbleiterschichten wird eine erste Maskierungsschicht und auf dieser eine Photolackschicht als zweite Maskierungsschicht abgeschieden. Eine in der Photolackschicht erzeugte Öffnung dient als Maske zur Erzeugung einer durch Unterätzung breiteren zweiten Öffnung in der zweiten Maskierungsschicht. Diese zweite Öffnung dient als Maske für eine kristallrichtungsabhängige anisotrope Ätzung der eine Kontaktschicht bildenden obersten Halbleiterschicht bis zu einer Stop-Schicht, wobei sich die Öffnung in der Kontaktschicht nach unten stark verjüngt. Nach Entfernen der StopSchicht unter der in der Kontaktschicht erzeugten Öffnung wird diese als Maske für eine erneute kristallrichtungsabhängige anisotrope Ätzung der darunter liegenden Halbleiterschicht benutzt, wobei in dieser wiederum eine sich nach unten stark verjüngende dritte Öffnung bis zu einer weiteren Stop-Schicht erzeugt wird. Nach Entfernen der weiteren Stop-Schicht unter der Öffnung wird durch die bis dahin beibehaltene Öffnung in der Photolackschicht im Lift-Off-Verfahren Gatemetall abgeschieden, welches die dritte Öffnung als Gatefuß vollständig ausfüllt und als Gatekopf von dem Halbleitermetall der Kontaktschicht beabstandet ist.

Die US 2004/0082158 A1 beschreibt ein Verfahren zur selbstjustierenden Erzeugung einer Doppel-Graben-Struktur eines High-Electron-Mobility-Transistors (HEMT). Dabei wird über der die Kontaktschicht für Source- und Drain-Elektroden bildenden obersten Halbleiterschicht eine Photolackschicht abgeschieden, in welcher eine größere hinterschnittene Öffnung und der Kontaktschicht zugewandt eine schmälere Öffnung erzeugt wird. Die schmälere Öffnung dient als Maske zur Erzeugung einer Öffnung in zwei unter der Photolackschicht liegenden HalbleiterSchichten, wobei in einem ersten Ätzschritt beide Halbleiterschichten geätzt und durch Unterätzen der Photolackschicht ein erster Graben bis zu einer StopSchicht erzeugt wird und in einem zweiten Ätzschritt durch selektives Ätzen der Kontaktschritt der Graben in der Kontaktschicht verbreitert wird. Gatemetall wird im Lift-Off-Verfahren abgeschieden, wobei die schmälere Öffnung der Photolackschicht als Maske für den Gatefuß und die breitere Öffnung der Photolackschicht als Maske für den Gatekopf dient.

Der Erfindung liegt die Aufgabe zugrunde, ein vorteilhaftes Verfahren zur Herstellung eines Halbleiterbauelements mit einer metallischen Gateelektrode und einer Doppelgrabenstruktur anzugeben.

Die Erfindung ist im Patentanspruch 1 beschrieben. Die abhängigen Ansprüche enthalten vorteilhafte Ausgestaltungen und Weiterbildungen der Erfindung.

Die Erzeugung der Doppelgrabenstruktur erfolgt durch das erfindungsgemäße Verfahren vorteilhafterweise in selbstjustierender Positionierung des breiten und des schmalen Grabens in mehreren Schritten, wobei in Zwischenschritten erzeugte Strukturen vorteilhafterweise als Maskierung für nachfolgende Ätzschritte dienen können. Auch für den Gatefuß ergibt sich eine selbstzentrierende Position innerhalb des schmalen Grabens.

Insbesondere kann mit der Öffnung in der Hilfsschicht als Hardmaske in einem Zwischenschritt ein erster Teilgraben in der Kontaktschicht freigelegt werden, welcher seinerseits zur Definition des schmalen Grabens in der Abschirmschicht dient, wofür vorteilhafterweise die Abschirmschicht eine oben liegende Stopschicht aufweist und der erste Teilgraben als Maskierung zur Ätzung einer Öffnung in diese Stopschicht eingesetzt wird. Der erste Teilgraben wird in einem nachfolgenden Schritt seitlich zur Bildung des breiten Grabens aufgeweitet, wobei eine definierte Unterätzung der Hilfsschicht in einer Zwischenschicht als Maskierung dient.

Die Erzeugung von Strukturen einschließlich der Herstellung von Öffnungen in Schichten und der Freilegung von Gräben oder Strukturen erfolgt in gebräuchlicher Weise durch in vielfacher Zusammensetzung und Anwendung bekannter Ätzmittel, welche insbesondere auch materialselektiv ausgewählt und eingesetzt werden können.

In vorteilhafter Weiterbildung kann auch der Gatekopf relativ zu dem Gatefuß in selbstjustierender Position hergestellt werden, wofür in Schichten, insbesondere Photolackschichten über der Hilfsschicht Öffnungen für die Form des Gatekopfes selbstjustierend zu der die Struktur des Gatefußes bestimmenden Öffnung in der Hilfsschicht erzeugt werden. Vorteilhafterweise erfolgt die Herstellung der Öffnungen in den Lackschichten über der Hilfsschicht durch erste engere Strukturen in den Lackschichten bis zur dazu selbstjustiert erzeugten Öffnung in der Hilfsschicht als die Ätzung der Grabenstruktur maskierende Hardmaske und anschließende Aufweitung dieser ersten Strukturen.

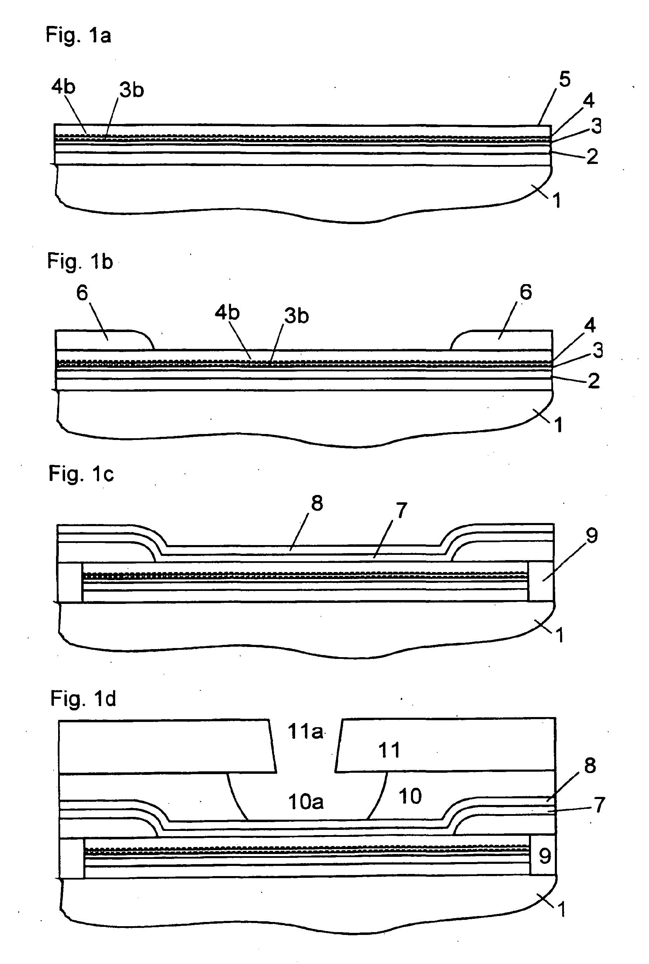

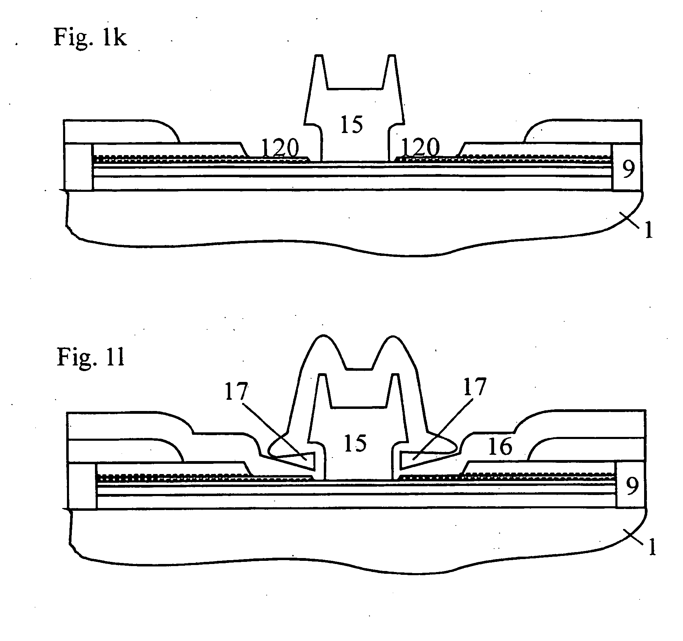

Die Erfindung ist nachfolgend anhand eines bevorzugten Ausführungsbeispiels unter Bezugnahme auf die Abbildungen Fig. 1a bis Fig. 1l in aufeinander folgenden Verfahrensstadien noch eingehend veranschaulicht.

Das erfindungsgemäße Verfahren beinhaltet eine in hohem Maße skalierbare und selbstjustierte Integration zur Definition des Gatebereiches mit Gatefuß und Gatekopf. Der Gatefuß kann dabei Abmessungen von z. B. 70 - 600 nm besitzen, während der Gatekopf typischerweise nach beiden Seiten um 50 - 300 nm breiter sein kann. Der Gatekopf wird zum Gatefuß selbstjustiert symmetrisch angeordnet. Die Gateelektrode, insbesondere der Gatefuß ist seinerseits zentriert in dem Doppelgraben angeordnet, dessen breiter und schmaler Graben gleichfalls selbstjustiert symmetrisch zueinander liegen.

Ausgehend von dem GaAs Substrat 0, definieren die Schichten 1-5 in Fig. 1a das Vertikalprofil eines Feldeffekt-Transistors, insbesondere eines pHEMT Hochfrequenz-Leistungsfeldeffekttransistors, das in seiner Dicken- und Elementstruktur in Abhängigkeit von der Anwendung variieren kann. Die Schichtendickenverhältnisse sind nicht maßstäblich zu nehmen. Grundsätzlich stellt 1 den Buffer dar, 2 bildet die Kanalschicht für das zweidimensionale Elektronengas, 3 ist eine Barrierenschicht mit oben liegender Stopschicht 3b, die zur definierten Ätzung des schmalen Recessgrabens beiträgt, 4 ist eine niedrigdotierte Abschirmschicht, die ebenfalls nach oben mit einer Stopschicht 4b abschließt, und die Schicht 5 als oberste Halbleiterschicht bildet eine hochdotierte Kontaktschicht zur niederohmigen Bauelementkontaktierung. Die Schichten 4 und 5 bestehen vorzugsweise aus GaAs und die Stopschicht 3b und 4b vorteilhafter weise aus AlAs oder InGaP.

Nach Definition ohmscher Kontakte 6 auf der Kontaktschicht 5 gemäss Fig. 1b erfolgt vorzugsweise durch PECVD die Abscheidung einer dielektrischen Zwischenschicht 7, vorzugsweise einer SiO₂-Schicht und einer dielektrischen Hilfsschicht 8, vorzugsweise einer Siliziumnitrid (SiN)-Schicht. Die Summe der absoluten Dicken der Schichten 4, 5, 7 und 8 liegt vorteilhafterweise unter oder nicht wesentlich über 150 mm, was für die Ausbildung der T-förmigen Gatemetallisierung günstig ist. Die laterale Isolation der Transistoren erfolgt durch eine fotolackmaskierte Implantation 9 (Fig. 1c).

Für den nächsten Lithografieprozessschritt wird eine Photolack-Doppelschicht, die vorzugsweise aus PMGI als unterer Lack 10 und einem dünnen positiven oberen Lack 11 auf der Hilfsschicht besteht, abgeschieden. Eine Belichtungsmaske wird relativ zu den ohmschen Kontakten justiert. Durch die Wahl der geeigneten Belichtungsparameter ergeben sich die Öffnungen 11 a im oberen Lack und 10a im unteren Lack. Dabei ist 10a größer als 11a, um eine für einen Lift-off-Prozess geeigneten Lacküberhang zu erzeugen. Dies ist in Fig. 1d dargestellt.

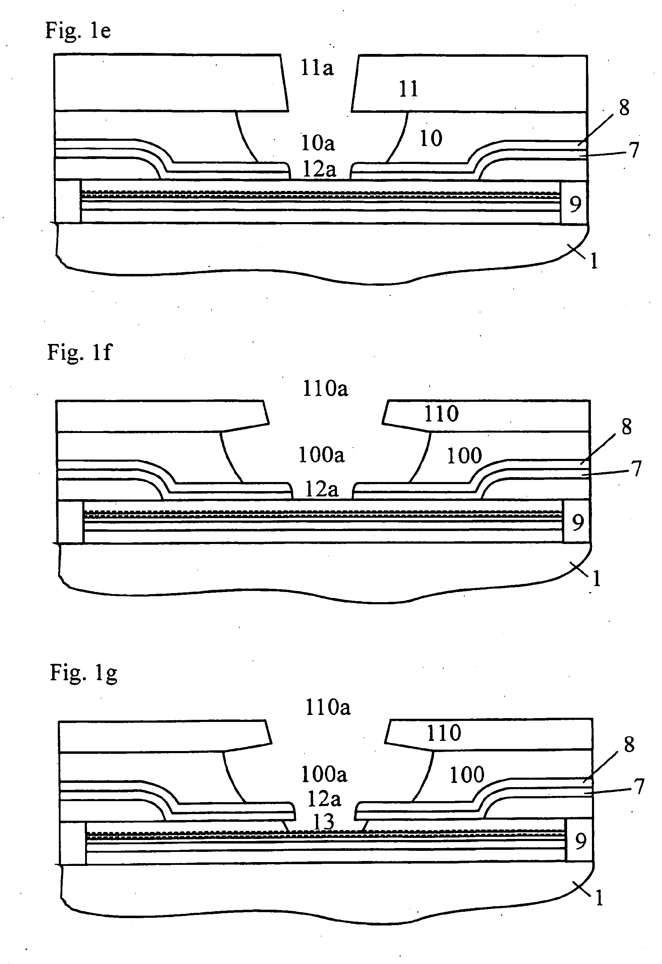

Die Öffnung 11a in der oberen Lackschicht bestimmt auch die spätere Form des Gatefußes. Durch anisotropes Plasmaätzen wird die Lackstruktur des oberen Lackes mit der Öffnung 11a in die Hilfsschicht 8 und die Zwischenschicht 7 übertragen. Es entsteht die Öffnung 12a in Fig. 1e, deren Seitenwände vorteilhafterweise abgerundet in die Oberseite der Hilfsschicht 8 übergehen, was vorteilhaft für die spätere Ausbildung der T-förmigen Gatemetallisierung ist.

Bevor weitere, insbesondere nasschemische Ätzungen die Doppelgrabenstruktur definieren, wird, z. B. durch ein isotropes Sauerstoffplasma, die Lackstruktur aufgeweitet, so dass die Öffnung 110a die laterale Begrenzung für den Gatekopf darstellt. Die Öffnung 100a im unteren Lack wird vorteilhafterweise mit vergrößert, so dass die überhängende Lackstruktur erhalten bleibt (siehe Fig. 1f).

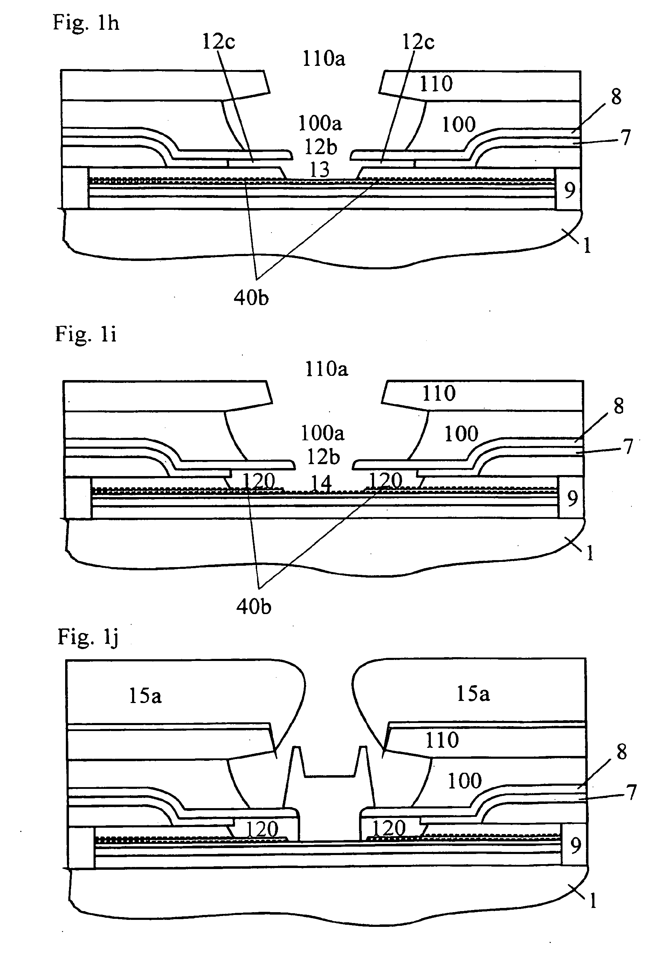

Fig. 1g zeigt nach einer ersten Ätzung der Kontaktschicht 5 bis zur Ätzstopschicht 4b mit der Öffnung 12a als Maske einen ersten Teilgraben 13, der lateral gegenüber der Öffnung 12a durch eine nasschemische Überätzung erweitert ist. Die Überätzung wird , z. B. durch Dauer des Ätzvorgangs, so eingestellt, dass die Breite des Teilgrabens 12 die für den schmalen Graben der Doppelgrabenstruktur vorgesehene Abmessung einnimmt. Im folgenden Prozessschritt wird durch eine hochselektive Ätzung der Oxidschicht 7 gegenüber der Hilfsschicht 8 und der Kontaktschicht 5 die Oxidschicht lateral abgetragen, so dass sich eine gegenüber 13 verbreiterte Unterätzung 12c ergibt (Fig. 1h). Die laterale Ausdehnung der Unterätzung 12c ist, z. B. über die Dauer des Ätzvorgangs, sehr genau einstellbar und wird so gewählt, dass die seitlichen Ränder der Unterätzung die vorgesehene laterale Dimension des breiten Grabens vorgegeben. Die Erzeugung von 12c wird vorteilhafterweise mit HF-haltigen Lösungen durchgeführt, wodurch gleichzeitig durch den Teilgraben 13 maskiert die Stopschicht 4b, die vorzugsweise aus AlAs besteht, lokal in den Teilgraben 13 entfernt wird. Die Öffnung in der Hilfsschicht 8 ist mit 12b bezeichnet und besitzt im wesentlichen dieselbe Öffnungsweite wie die Öffnung 12a in der Doppelschicht 7, 8.

Nachfolgend werden, vorzugsweise in einem gemeinsamen Ätzschritt, in der Kontaktschicht 5 der breite Graben 120 und in der Abschirmschicht 4 der schmale Graben 14 der Doppelgrabenstruktur geätzt und der in Fig. 1i gezeigte Querschnitt erzeugt. Die Ätzung der Kontaktschicht wird lateral durch die Unterätzung 12c aus Fig. 1h in der Oxidschicht 7 maskiert. Die im Mittelbereich seitlich des Teilgrabens 13 verbliebene Stopschicht 40b maskiert die Ätzung des schmalen Grabens 14 in der Abschirmschicht 4. Dadurch entsteht die durch den bereiten Graben 120 und den schmalen Graben 14 gebildete Doppelgrabenstruktur, deren laterale Dimensionen bereits durch die Öffnung 11a und die Oxidunterätzung festgelegt werden. Nach Entfernung der frei liegenden Stopschichten wird das Gatemetall 15 aufgedampft. Dabei maskiert die Öffnung 12b die laterale Metallbegrenzung es Gatefußes und 110a die des Gatekopfes. Dadurch entsteht das in Fig. 1j dargestellte T-förmige metallische Gate.

Nach dem Gate Lift-off werden die Hilfsschicht 7 und die Zwischenschicht 8, z. B. in einem CF₄-basierten isotropen Plasma entfernt (Fig. 1k) und anschießend die Oberflächen der Grabenstruktur passiviert. Durch ganzflächige, im wesentlichen isotrope Abscheidung einer vorzugsweise aus SiN bestehenden Passivierungsschicht 16 und durch die T-förmige Gateform entstehen unterhalb der überhängenden Gatekopfbereich die Hohlräume 17 (Fig. 11), die die Rückkoppelkapazitäten vorteilhaft reduzieren.

## Patentansprüche

1. Verfahren zur Herstellung eines Halbleiterbauelements mit einer metallischen Gateelektrode mit einem breiteren Gatekopf und einem schmaleren Gatefuß, welcher in einer Doppelgrabenstruktur mit einem breiten und einem schmalen Graben angeordnet ist, wobei
- eine Halbleiterschichtenfolge für einen Feldeffekttransistor, insbesondere einen pHEMT Transistor abgeschieden wird mit einer Kanalschicht (2), über dieser einer Barrierenschicht (3), über dieser einer niedrigdotierten Abschirmschicht (4) mit einer oben liegenden Stopschicht (4b) und über dieser einer hochdotierten Kontaktschicht (5),
- auf der Kontaktschicht (5) eine Zwischenschicht (7) und eine Hilfsschicht (8) abgeschieden werden,
- in der Hilfsschicht (8) und der Zwischenschicht (7) eine die Struktur des Gatefußes bestimmende erste Öffnung (12a) erzeugt und mit der Struktur des schmalen Grabens als erster Teilgraben (13) in die Kontaktschicht (5) bis zu der oben liegenden Stopschicht (4b) der Abschirmschicht (4) übertragen wird,
- durch selektive Ätzung der Zwischenschicht (7) die Hilfsschicht (8) mit der Struktur (12c) des breiten Grabens unterätzt wird,
- mit dem ersten Teilgraben (13) als Maske eine Öffnung in der oben liegenden Stopschicht (4b) der Abschirmschicht erzeugt wird,
- mit der Struktur (12c) in der Zwischenschicht als Maskierung der Teilgraben (13) in der Kontaktschicht (5) zu dem breiten Graben (120) erweitert wird,
- mit der Öffnung in der oben liegenden Stopschicht (4b) der Abschirmschicht der schmale Graben (14) in der Abschirmschicht (4) bis zur Barrierenschicht (3) freigelegt wird,
- Gatemetall für den Gatefuß mit der Öffnung (12b) in der Hilfsschicht als Maske in den schmalen Graben (14) und für den Gatekopf auf die Hilfsschicht (8) ab geschieden wird.

2. Verfahren nach Anspruch 1, **dadurch gekennzeichnet, dass** bei der Abscheidung der Halbleiterschichtenfolge auch auf der Barrierenschicht (3) eine oben liegende Ätzstopschicht (3b) erzeugt wird.

3. Verfahren nach Anspruch 1 oder 2, **dadurch gekennzeichnet, dass** nach Ätzung der Doppelgrabenstruktur und vor Abscheidung des Gatemetalls gegebenenfalls noch in der Doppelgrabenstruktur frei liegende Stopschichten (40b) entfernt werden.

4. Verfahren nach einem der Ansprüche 1 bis 3, **dadurch gekennzeichnet, dass** nach dem Abscheiden des Gatemetalls die Hilfsschicht (8) und die Zwischenschicht (7) entfernt werden.

5. Verfahren nach Anspruch 4, **dadurch gekennzeichnet, dass** nach der Entfernung der Hilfsschicht (8) und der Zwischenschicht (7) eine Passivierungsschicht (16) abgeschieden wird.

6. Verfahren nach einem der Ansprüche 1 bis 5, **dadurch gekennzeichnet, dass** der Gatekopf im Lift-off-Verfahren hergestellt wird.

7. Verfahren nach Anspruch 6, **dadurch gekennzeichnet, dass** die Maske für das Lift-off-Verfahren vor der Herstellung der Doppelgrabenstruktur in Lackschichten (10, 11) über der Hilfsschicht (8) erzeugt und bis zur Abscheidung des Gatemetalls beibehalten wird.

8. Verfahren nach Anspruch 7, **dadurch gekennzeichnet, dass** die Öffnung (120) in der Hilfsschicht (8) und der Zwischenschicht (7) selbstjustiert zu einer Maskenstruktur in den Lackschichten (10, 11) für den Gatekopf erzeugt wird.

## Claims

1. Method for producing a semiconductor component comprising a metallic gate electrode having a wider gate head and a narrower gate foot, which is arranged in a double trench structure having a wide and a narrow trench, wherein
- a semiconductor layer sequence for a field effect transistor, in particular a pHEMT transistor, is deposited, comprising a channel layer (2), thereabove a barrier layer (3), thereabove a lightly doped screening layer (4) with an overlying stop layer (4b) and thereabove a highly doped contact layer (5),
- an intermediate layer (7) and an auxiliary layer (8) are deposited on the contact layer (5),
- a first opening (12a) which determines the structure of the gate foot, is produced in the auxiliary layer (8) and the intermediate layer (7) and is transferred with the structure of the narrow trench as first partial trench (13) into the contact layer (5) as far as the overlying stop layer (4b) of the screening layer (4),
- by means of selective etching of the intermediate layer (7) the auxiliary layer (8) is undercut with the structure (12c) of the wide trench,
- with the first partial trench (13) as mask, an opening is produced in the overlying stop layer (4b) of the screening layer,
- with the structure (12c) in the intermediate layer as masking, the partial trench (13) in the contact layer (5) is widened to form the wide trench (120),
- with the opening in the overlying stop layer (4b) of the screening layer, the narrow trench (14) in the screening layer (4) is uncovered as far as the barrier layer (3)
- gate metal is deposited for the gate foot with the opening (12b) in the auxiliary layer as mask into the narrow trench (14) and for the gate head onto the auxiliary layer (8).

2. Method according to Claim 1, **characterized in that**, during the deposition of the semiconductor layer sequence, an overlying etching stop layer (3b) is also produced on the barrier layer (3).

3. Method according to Claim 1 or 2, **characterized in that**, after the etching of the double trench structure and before the deposition of the gate metal, stop layers (40b) that are still uncovered in the double trench structure, if appropriate, are removed.

4. Method according to any of Claims 1 to 3, **characterized in that** the auxiliary layer (8) and the intermediate layer (7) are removed after the deposition of the gate metal.

5. Method according to Claim 4, **characterized in that** a passivation layer (16) is deposited after the removal of the auxiliary layer (8) and the intermediate layer (7).

6. Method according to any of Claims 1 to 5, **characterized in that** the gate head is produced by the lift-off method.

7. Method according to Claim 6, **characterized in that** the mask for the lift-off method is produced before the production of the double trench structure in resist layers (10, 11) above the auxiliary layer (8) and is maintained until the deposition of the gate metal.

8. Method according to Claim 7, **characterized in that** the opening (120) in the auxiliary layer (8) and the intermediate layer (7) is produced in a self-aligned fashion with respect to a mask structure in the resist layers (10, 11) for the gate head.

## Revendications

1. Procédé de fabrication d'un composant semiconducteur qui présente une électrode métallique de grille à tête de grille large et pied de grille étroit disposée dans une structure à double sillon dotée d'un sillon large et d'un sillon étroit, dans lequel
- une succession de couches semi-conductrices pour un transistor à effet de champ, en particulier un transistor pHEMT, est déposée avec une couche de canal (2), au-dessus de celle-ci une couche de barrière (3), au-dessus de celle-ci une couche de blindage (4) faiblement dopée et par dessus une couche d'arrêt (4b) ainsi qu'au-dessus de cette dernière une couche de contact (5) fortement dopée,
- une couche intermédiaire (7) et une couche auxiliaire (8) sont déposées sur la couche de contact (5),
- une première ouverture (12a) qui définit la structure du pied de grille est formée dans la couche auxiliaire (8) et la couche intermédiaire (7) et est transférée avec la structure du sillon étroit comme premier sillon partiel (13) dans la couche de contact (5) jusqu'à la couche d'arrêt (4b), située dans le haut, de la couche de blindage (4),
- la couche auxiliaire (8) qui présente la structure (12c) en large sillon est gravée par dessous par gravure sélective de la couche intermédiaire (7),
- une ouverture est formée dans la couche d'arrêt (4b), située dans le haut, de la couche de blindage en utilisant le premier sillon partiel (13) comme masque,
- le sillon partiel (13) est agrandi dans la couche de contact (5) jusqu'au large sillon (120) en utilisant la structure (12c) de la couche intermédiaire comme masque,
- l'étroit sillon (14) ménagé dans la couche de blindage (4) est libéré jusqu'à la couche de barrière (3) avec l'ouverture ménagée dans la couche d'arrêt (4b), située dans le haut, de la couche de blindage,
- le métal de grille pour le pied de grille est déposé dans le sillon étroit (14) en utilisant l'ouverture (12b) ménagée dans la couche auxiliaire comme masque et est déposé pour la tête de grille sur la couche auxiliaire (8).

2. Procédé selon la revendication 1, **caractérisé en ce que** lors du dépôt de la succession de couches semi-conductrices, on forme également une couche (3b) d'arrêt de gravure, située dans le haut, sur la couche de barrière (3).

3. Procédé selon les revendications 1 ou 2, **caractérisé en ce qu'**après la gravure de la structure en double sillon et avant le dépôt du métal de grille, des couches d'arrêt (40b) éventuellement libérées dans la structure en double sillon sont encore enlevées.

4. Procédé selon l'une des revendications 1 à 3, **caractérisé en ce qu'**après le dépôt du métal de grille, la couche auxiliaire (8) et la couche intermédiaire (7) sont enlevées.

5. Procédé selon la revendication 4, **caractérisé en ce qu'**après l'enlèvement de la couche auxiliaire (8) et de la couche intermédiaire (7), une couche de passivation (16) est déposée.

6. Procédé selon l'une des revendications 1 à 5, **caractérisé en ce que** la tête de grille est réalisée par un procédé de relèvement.

7. Procédé selon la revendication 6, **caractérisé en ce que** le masque utilisé pour l'opération de relèvement est formé avant la réalisation de la structure en double sillon dans des couches de vernis (10, 11) situées au-dessus de la couche auxiliaire (8) et est conservé jusqu'au dépôt du métal de grille.

8. Procédé selon la revendication 7, **caractérisé en ce que** l'ouverture (120) ménagée dans la couche auxiliaire (8) et dans la couche intermédiaire (7) est formée par auto-ajustement pour obtenir une structure de masque dans les couches de vernis (10, 11) prévues pour la tête de grille.
